(19) Europäisches Patentamt
European Patent Office
Office européen des brevets

(11) **EP 1 494 197 B1**

(12) **EUROPEAN PATENT SPECIFICATION**

(45) Date of publication and mention
of the grant of the patent:
**03.11.2010 Bulletin 2010/44**

(51) Int Cl.:
*G09G 3/28* *(2006.01)*     *H03K 17/0416* *(2006.01)*
*G09G 3/288* *(2006.01)*

(21) Application number: **04013702.8**

(22) Date of filing: **11.06.2004**

(54) **Method for generating short-duration pulses on a plurality of columns or rows of a plasma display and device for implementing said method**

Verfahren zur Erzeugung von kurzzeitigen Pulsen in einer Vielzahl von Spalten und Zeilen einer Plasmaanzeige und Anordnung zur Durchführung des Verfahrens

Méthode pour la génération d'impulsion de courte durée dans une pluralité de colonnes ou de rangées d'un afficheur plasma et dispositif pour la mise en oeuvre de la méthode

(84) Designated Contracting States:
**AT BE BG CH CY CZ DE DK EE ES FI FR GB GR HU IE IT LI LU MC NL PL PT RO SE SI SK TR**

(30) Priority: **02.07.2003 FR 0308038**

(43) Date of publication of application:
**05.01.2005 Bulletin 2005/01**

(73) Proprietor: **Thomson Licensing**
**92130 Issy-les-Moulineaux (FR)**

(72) Inventors:
• **Gagnot, Dominique,**
**c/o Thomson**
**92648 Boulogne Cedex (FR)**
• **Lacoste, Ana,**
**c/o Thomson**
**92648 Boulogne Cedex (FR)**

• **Meysen, Claude,**
**c/o Thomson**
**92648 Boulogne Cedex (FR)**

(74) Representative: **Le Dantec, Claude et al**
**Technicolor**
**1-5 rue Jeanne d'Arc**
**92130 Issy-les-Moulineaux (FR)**

(56) References cited:
**DE-A1- 19 737 662**     **US-B1- 6 175 192**

• **WEBER L F ET AL: "ENERGY RECOVERY SUSTAIN CIRCUIT FOR THE AC PLASMA DISPLAY" SID INTERNATIONAL SYMPOSIUM DIGEST OF TECHNICAL PAPERS. NEW ORLEANS, MAY 12 - 14, 1987, NEW YORK, PALISADES INST. FOR RESEARCH, US, vol. 18, 12 May 1987 (1987-05-12), pages 92-95, XP000608669**

**EP 1 494 197 B1**

## Description

The present invention relates to a method for generating pulses having a high amplitude and short duration on a plurality of columns or rows of a plasma display. These pulses are especially intended to be applied to the columns or the rows of the display during the sustain periods of the cells of the display. This method is intended for use in an AC plasma display panel.

There are various types of AC plasma display panel (hereinafter referred to as a PDP): those which use only two crossed electrodes to define a cell, as described in the patent FR 2 417 848, and those of the "coplanar sustain" type, notably known from the European patent document EP-A-0 135 382, in which each cell is defined at the point where a pair of so-called "sustain" electrodes crosses one or more other so-called "column" electrodes, which are used especially for addressing the cells. The present invention is especially intended for use in an AC PDP of the type with coplanar sustain.

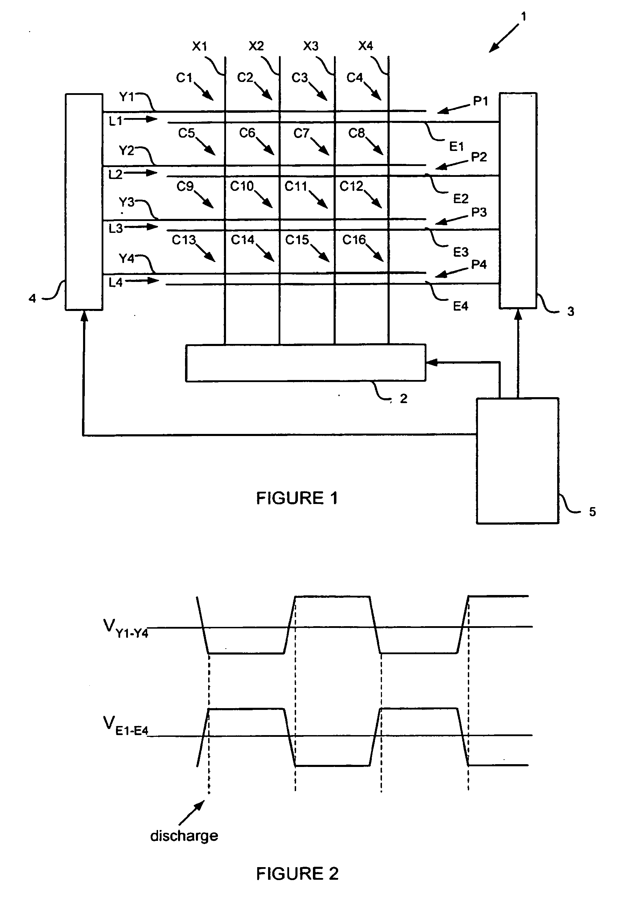

The operation and the structure of an AC PDP with coplanar sustain is explained hereinafter with reference to Figure 1. The display 1 comprises column electrodes X1 to X4 that are orthogonal to pairs P1 to P4 of sustain electrodes. Each crossing of a column electrode X1 to X4 with a pair of sustain electrodes P1 to P4 defines a cell C1 to C16 corresponding to an elementary point of the image. In the non-limiting example of the description, only 4 column electrodes X1 to X4 and only 4 pairs of sustain electrodes P1 to P4, which form 4 rows L1 to L4 of cells, are represented. However, the display may, of course, comprise many more rows of cells.

The column electrodes X1 to X4 are generally only used for the address operation. They are each connected in a conventional manner to a column driver 2.

The electrode pairs P1 to P4 each comprise a so-called address-sustain electrode Y1 to Y4 and a so-called sustain-only electrode E1 to E4. The address-sustain electrodes Y1 to Y4 fill an address role in cooperation with the column electrodes X1 to X4, and they fill a sustain role with the sustain-only electrodes E1 to E4. The sustain-only electrodes E1 to E4 are connected together and to a pulse generator 3 from which they all simultaneously receive a periodic voltage pulse train for performing sustain cycles.

The address-sustain electrodes Y1 to Y4 are independent and are connected to a row driver 4 from which they notably receive, during a sustain phase, a periodic voltage pulse train synchronized to that applied to the sustain-only electrodes E1 to E4 but phase-shifted with respect to the latter, and, during an address phase, a basic pulse waveform synchronized to the signals applied to the column electrodes X1 to X4.

The synchronization between the various signals applied to the various electrodes is provided by a synchronization controller 5 connected to the drivers 2 and 4 and to the generator 3.

The voltage pulses applied to the sustain electrode pairs P1 to P4 during a sustain phase are shown in Figure 2. Each rising edge of the signal applied to the address-sustain electrodes Y1 to Y4 corresponds to a falling edge of the signal applied to the sustain-only electrodes E1 to E4. A sustain discharge occurs in the cells C1 to C16 following these edges. Regarding the signal applied to the column electrodes X1 to X4 during this phase, it is kept at a low potential.

As can be seen in this figure, the sustain discharges in the cells of the PDP are produced by inversion of the coplanar voltage, in other words by inverting the voltage between the sustain-address electrodes Y1 to Y4 and the sustain-only electrodes E1 to E4.

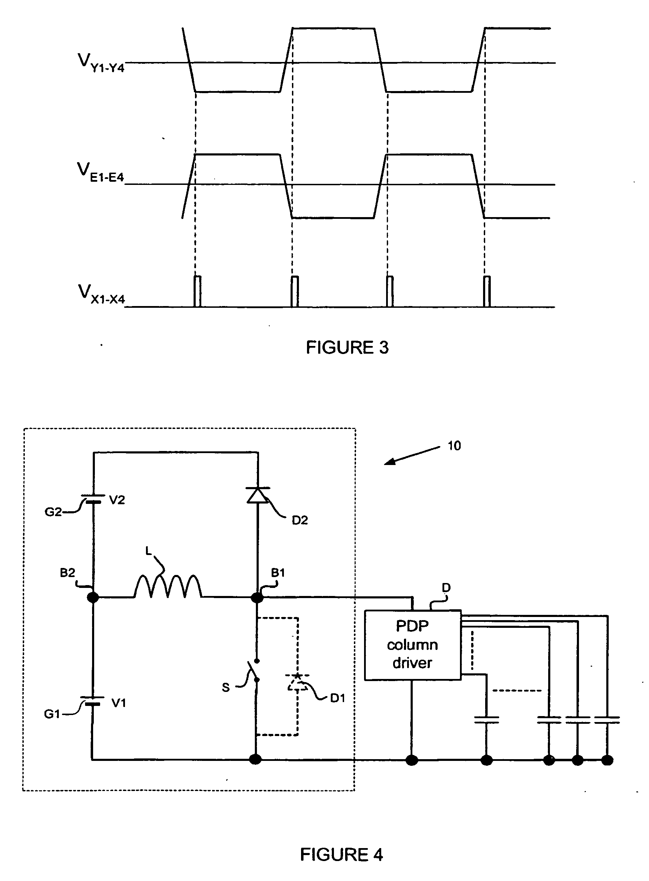

Additionally, from International Patent Application WO 02/099779, it is known that, during the cell sustain phase, pulses synchronous with the sustain signal applied to the sustain electrode pairs P1 to P4 can be applied to the column electrodes X1 to X4 in order to promote the triggering of the cell discharges and thus increase their luminous efficiency, and in order to control more precisely the moment of discharge following inversion of the coplanar voltage. This method is illustrated in Figure 3.

The pulse signal applied to the column electrodes X1 to X4 to promote the discharge between the coplanar electrodes is shown in this figure. At each rising or falling edge of the signals applied to the coplanar electrodes, or slightly later, a pulse of high amplitude, of the order of a hundred volts, and of short duration, around 100 nanoseconds, is applied to the column electrodes of the PDP.

In order to implement this method, the control circuit of the PDP must be equipped with one or more pulse generators capable of generating such pulses into a highly capacitive load corresponding to the load of the column electrodes X1 to X4 of the display. Patent Application WO 02/099779 does not propose any means of generating these pulses.

The present invention proposes a method and a device for generating a periodic signal comprising high-amplitude, short-duration pulses into a highly capacitive load.

The invention also relates to a method for generating a periodic voltage signal, of period P, comprising pulses of short duration T and high amplitude A to be applied to a plurality of columns or rows of a plasma display panel comprising a plurality of cells located at the intersections of said rows and columns, where the cells can be in a written state or an erased state. This method comprises the following steps:

-    during a first phase of duration T1, applying a first DC voltage across the terminals of a solenoid so that the latter stores current in the form of magnetic energy;
-    during a second phase of duration T2, applying a voltage of amplitude A across the terminals of the capacitors of said plurality of columns or rows of the plasma display and discharging into the latter a part of the current stored in the solenoid up to the point where the voltage across the terminals of the capacitors of said plurality of columns or rows of the plasma display reaches the amplitude A;

- during a third phase of duration T3, holding said voltage of amplitude A across the terminals of said plurality of plasma display columns or rows so as to create a matrix discharge current between the columns and rows of the display cells in the written state and bring the current stored in said solenoid to zero;
- during a fourth phase of duration T4, charging the solenoid with the current stored in the form of capacitive energy in the capacitors of said plurality of columns or rows of the plasma display until the point when the voltage across the terminals of the display columns has fallen to zero;
- during a fifth phase of duration T5, bringing the current stored in the solenoid to zero.

The signal generated is applied to a plurality of columns of the PDP if the pulses have a positive amplitude and to a plurality of rows of the PDP if the pulses have a negative amplitude. These pulses are synchronous with the rising and falling edges of the sustain signal applied to the sustain electrode pairs.

According to a variant embodiment, the method further comprises an additional phase, consecutive to the fifth phase, of duration T6 corresponding to an idle phase during which no current is supplied to said plurality of columns or rows of the display and the voltage across the terminals of the latter is maintained at zero.

The invention also relates to a device for implementing the aforementioned basic method or its variant. According to a first embodiment, the device generates a pulse signal which is applied to a plurality of columns of the PDP. It comprises:

- a solenoid of which a first end is connected to said plurality of columns;
- a first DC voltage generator whose positive terminal is connected to a second end of said solenoid and whose negative terminal is connected to earth, which first generator is designed to generate said first DC voltage V1;
- a first switching element connected between the first end of the solenoid and earth, which first switching element is in the closed position during said first and fifth phases and in the open position during said second, third and fourth phases;
- a second DC voltage generator whose negative terminal is connected to the positive terminal of the first voltage generator and whose positive terminal is connected, via a first diode, to the first end of the solenoid, the cathode and the anode of said first diode being connected respectively to the positive terminal of said second DC voltage generator and to the first end of said solenoid, which second DC voltage generator is designed to generate, in cooperation with the first DC voltage generator (G1), the voltage of amplitude A.

According to a second embodiment for implementing the variant method, the device generates a pulse signal that is also applied to a plurality of columns of the PDP and comprises:

- a solenoid of which a first end is connected to said plurality of columns;
- a first switching element connected between the first end of the solenoid and earth, which first switching element is in the closed position during the first, fifth and sixth phases and in the open position during the second, third and fourth phases;
- a first DC voltage generator whose positive terminal is connected, via a second switching element, to a second end of said solenoid and whose negative terminal is connected to earth, which first generator is designed to generate said first DC voltage V1, said second switching element being in the closed position during the first five phases and in the open position during the sixth phase;
- a second DC voltage generator whose negative terminal is connected to the positive terminal of the first voltage generator and whose positive terminal is connected, via a first diode, to the first end of the solenoid, the cathode and the anode of said first diode being respectively connected to the positive terminal of said second DC voltage generator and to the first end of said solenoid, which second DC voltage generator is designed to generate, in cooperation with the first DC voltage generator (G1), the voltage of amplitude A.

According to a third embodiment for implementing the method, the device generates a pulse signal which is applied to a plurality of rows of the PDP. It comprises:

- a solenoid of which a first end is connected to said plurality of rows;
- a first DC voltage generator whose negative terminal is connected to a second end of said solenoid and whose positive terminal is connected, via a switching element, to said first end, said first generator being designed to generate said first DC voltage V1, said switching element being in the closed position during said first and fifth phases and in the open position during said second, third and fourth phases;
- a second DC voltage generator whose positive terminal is connected to the negative terminal of the first voltage generator and whose negative terminal is connected to earth, which second DC voltage generator is designed to generate, in cooperation with the first DC voltage generator (G1), the voltage of amplitude A;
- a diode whose cathode and anode are connected to said first end of said solenoid and to earth, respectively.

According to a fourth embodiment for implementing the method, the device generates a pulse signal which is also applied to a plurality of rows of the PDP. It comprises:

- a solenoid of which a first end is connected to said plurality of rows;
- a first DC voltage generator whose positive terminal is connected, via a first switching element, to the first end of the solenoid and whose negative terminal is connected, via a second switching element, to a second end of said solenoid, said first generator being designed to generate said first DC voltage V1, said first switching element being in the closed position during the first, fifth and sixth phases and in the open position during the second, third and fourth phases, and said second switching element being in the closed position during the first five phases and in the open position during the sixth phase;
- a second DC voltage generator whose positive terminal is connected to the negative terminal of the first voltage generator and whose positive terminal is connected to earth, which second DC voltage generator is designed to generate, in cooperation with the first DC voltage generator (G1), the voltage of amplitude A;
- a diode whose cathode and anode are connected to the first end of the solenoid and to earth, respectively.

Lastly, the invention also relates to a plasma display panel comprising a plurality of cells located at the intersections of rows and columns, a row driver circuit and a column driver circuit and a device such as that previously described.

The invention will be better understood, and other features and advantages will become apparent upon reading the description that follows which makes reference to the appended drawings, among which:

- Figure 1, already described above, shows a schematic drawing of a PDP to which the invention may be applied,
- Figure 2, already described above, shows the signals that are conventionally applied to the sustain electrode pairs of the PDP during a sustain phase,
- Figure 3, already described above, shows the signals applied to the sustain electrode pairs of the PDP during a sustain phase in Patent Application WO 02/099779,
- Figure 4 shows a first device according to the invention that is capable of generating, in synchronization with the rising and falling edges of the signals applied to the sustain electrode pairs of the PDP, periodic pulses of high amplitude and short duration on the column electrodes of the PDP,

- Figure 5 shows the voltage signal generated by the device in Figure 4 and the signal of the current flowing through a solenoid of the device in Figure 4,
- Figures 6A to 6E illustrate the different phases of operation of the device in Figure 4,
- Figure 7 shows a second device according to the invention,
- Figure 8 shows the voltage signal generated by the device in Figure 7 and the signal of the current flowing through a solenoid of the device in Figure 7,
- Figures 9A to 9F illustrate the six phases of operation of the device in Figure 7,
- Figure 10 shows a third device according to the invention that is capable of generating, in synchronization with the rising and falling edges of the sustain signals, periodic pulses of high amplitude and short duration on the rows of the PDP and
- Figure 11 shows a fourth device that is capable of generating, in synchronization with the rising and falling edges of the sustain signals, periodic pulses of high amplitude and short duration on the rows of the PDP.

According to the invention, a method and a device are proposed for generating short pulses on the column electrodes X1 to X4 or on the sustain electrode pairs of the PDP. This device may or may not be integrated into the driver circuit 2 or 4 in Figure 1.

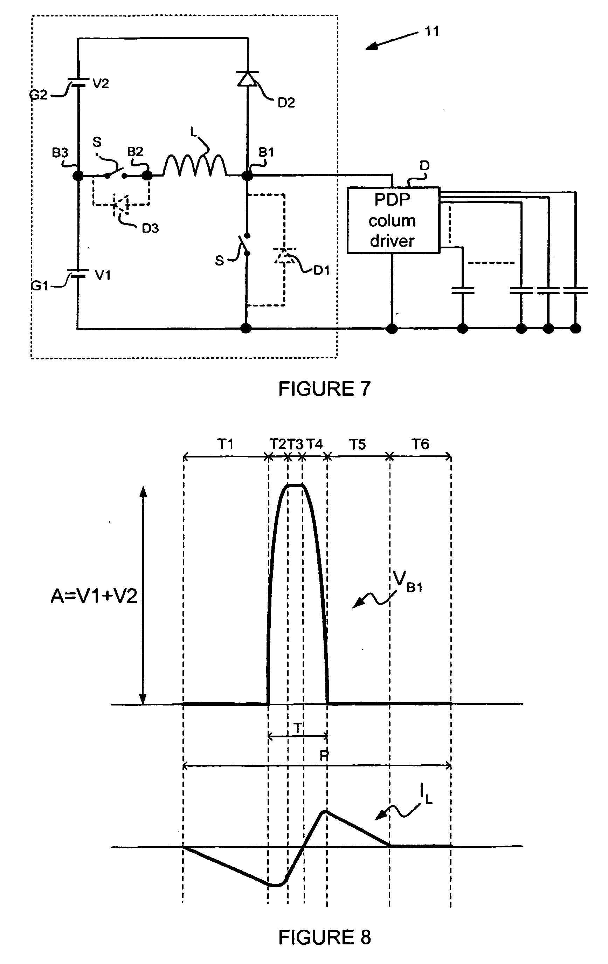

Two embodiments, illustrated in Figures 4 and 7, are proposed for generating pulses on the column electrodes of the PDP.

In these two figures, the device according to the invention is connected via a PDP column driver circuit to a group of columns of the PDP. The PDP columns are represented in these figures by their capacitors.

With reference to Figure 4, the device (reference 10) comprises a solenoid L for storing magnetic energy and discharging it into the capacitors of the PDP columns.

The solenoid L is connected, by a first end B1, to said group of column electrodes of the PDP via said driver circuit (reference D). The second end, B2, of the solenoid is connected to the positive terminal of a voltage source G1 capable of delivering a DC voltage V1. The negative terminal of the source G1 is connected to earth. A switching element S, operating as an on/off switch, is connected between the end B1 of the solenoid L and earth. This switching element is operated by a control circuit not shown in the figure. It is controlled to be either in a closed state, in which state the end B1 of the solenoid L is connected to earth, or in an open state, in which state the end B1 of the solenoid L is disconnected from earth. A diode D1 can be mounted in parallel with the switch S, with its cathode at the end B1 of the solenoid L. This diode generally corresponds to the diode of the MOS transistor used as the switch S.

A second source of voltage G2, capable of delivering a voltage V2, is connected across the terminals of the solenoid L via a second diode D2. The negative terminal of the source G2 is connected to the end B2 of the solenoid L and the cathode of the diode D2 is connected to the positive terminal of the source G2.

The value of the voltages V1 and V2 and the duty cycle of the control signal of the switch S will be defined in an example presented below.

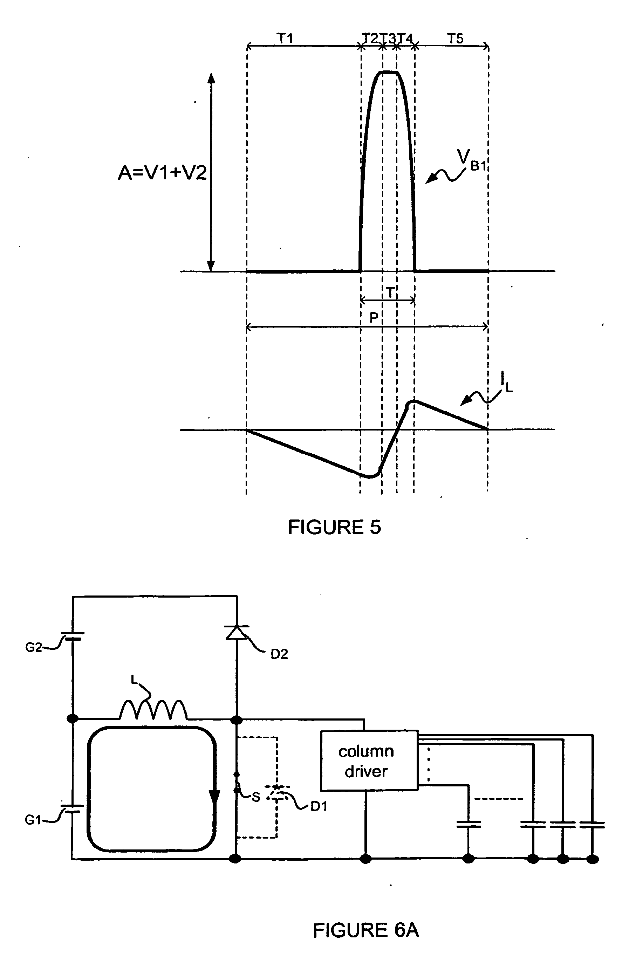

The operation of this device can be seen from the illustrations in Figures 5 and 6A to 6E. Figure 5 shows the waveform of the voltage applied to the input of the driver circuits as well as the waveform of the current flowing through the solenoid L of the generator. The pulses of the voltage signal supplied to the column electrodes of the PDP have an amplitude A, a duration T and a period P.

According to the invention, the method for generating the voltage signal supplied to the column electrodes of the PDP comprises 5 phases:

- a first phase of duration T1, illustrated by Figure 6A, during which the solenoid L stores current in the form of magnetic energy,

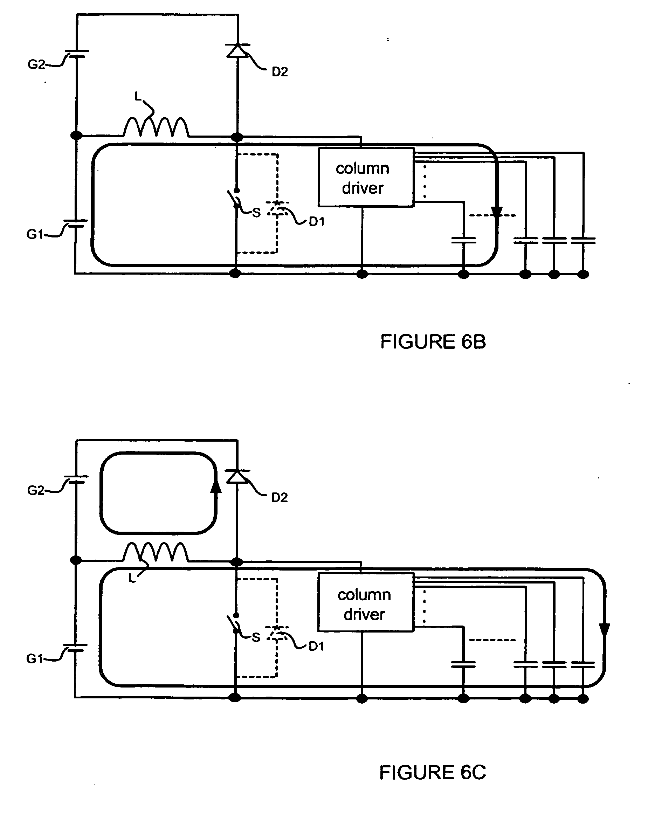

- a second phase of duration T2, illustrated by Figure 6B, during which a part of the current stored in the solenoid L is discharged into the columns of the PDP via the column driver circuit up to the point where the voltage across the terminals of the display columns reaches the amplitude A,

- a third phase of duration T3, illustrated by Figure 6C, during which the voltage of amplitude A is maintained across the terminals of the PDP columns so as to create a matrix discharge current between the columns and the rows of the PDP cells in the written state and bring the current stored in said solenoid to zero,

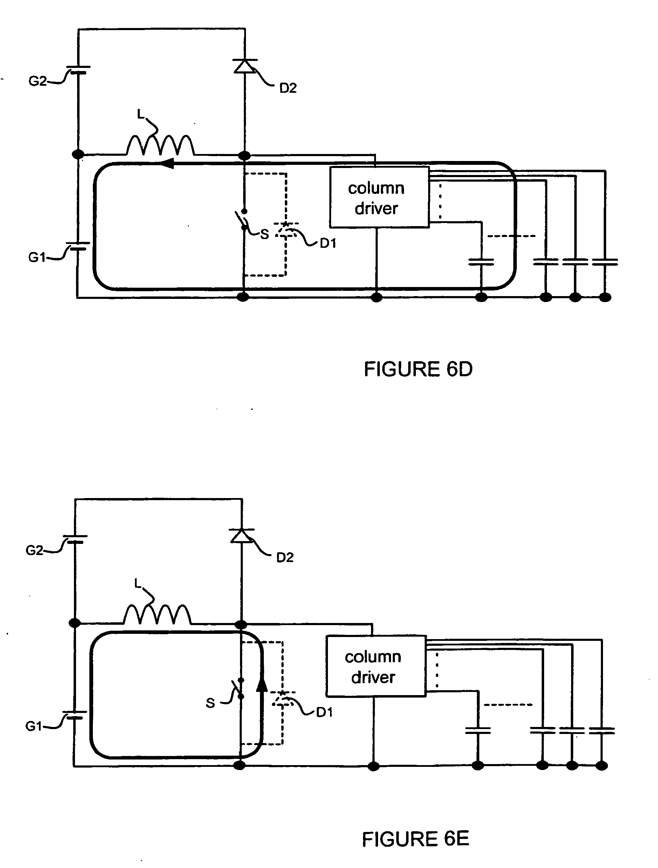

- a fourth phase of duration T4, illustrated by Figure 6D, during which the solenoid L is charged with the current stored in the capacitors of the columns of the PDP until the point when the voltage across the terminals of the PDP columns has fallen to zero,

- a fifth phase of duration T5, illustrated by Figure 6E, during which the current flowing through the solenoid L is brought to zero.

With reference to Figure 6A, the switching element S is set in a closed state during the period of duration T1. A current $I_L$ flows through the circuit formed by the voltage source G1, the solenoid L and the switching element S. The intensity of the current $I_L$ increases as it is being stored in the solenoid L. According to the convention chosen for illustrating this process, the current $I_L$ is negative during this period. Since the input of the driver circuit D is short-circuited to earth by the switching element S, the voltage across the terminals of the PDP columns is zero.

With reference to Figure 6B, the switching element S is open during the period of duration T2. A part of the energy stored in the solenoid L is now discharged into the PDP columns up to the point where the voltage across the terminals of the columns reaches the desired value A.

With reference to Figure 6C, this voltage across the terminals of the columns of the PDP is maintained over the duration T3 until the point when the current $I_L$ flowing through the solenoid has fallen to zero. During this phase, the switching element S is held in the open state. The remaining current in the solenoid L is, for the one part, transferred into the columns comprising cells in the written state and, for the other, absorbed by the voltage source G2 via the diode D2. The current transferred to the PDP columns comprising cells in the written state depends on the number of cells of the PDP in the written state. The greater this number, the lower the current absorbed by the voltage source G2. The current transmitted to the cells in the written state is an ignition current corresponding to a matrix discharge current between the row and the column of the cell. This matrix discharge current contributes to the improvement of the sustain discharge within the cell. The value of the current remaining in the solenoid L at the beginning of this phase is advantageously chosen to be equal to the value of the matrix discharge current required when all the cells of the PDP are in the written state.

With reference to Figure 6D, when the solenoid has completely discharged itself, the capacitive energy now stored in the capacitors of the columns of the PDP is restored to the solenoid L. The current $I_L$ now changes direction. The amplitude of the current $I_L$ reached at the end of this period of duration T4 is lower than that reached at the end of the period of duration T1 since energy has been absorbed by the voltage source G2 during the period of duration T3. The voltage across the terminals of the PDP columns falls to zero. During this period, the switching element is held in the open state.

Lastly, with reference to Figure 6E, the energy stored in the solenoid L is discharged into the voltage source G1 until the current $I_L$ has become zero. During this period, the state of the switching element, open or closed, is irrelevant since, if it were in the open state, the current $I_L$ would flow through the diode D1.

The voltage values V1 and V2, the durations T1, T2, T3, T4 and T5 as well as the inductance value L of the solenoid are set by the following rules:

$$-\frac{V1}{V2} \approx \frac{T2 + T3 + T4}{T1 + T5}$$

$$-V1 + V2 = A$$

- T2 + T3 + T4 = $\pi \sqrt{LC}$ where C is the capacitive load of the group of columns controlled by the driver circuit D.

Furthermore, the period P = T1+T2+T3+T4+T5 is equal to the half-period P'/2 of the sustain signal applied to the sustain electrode pairs of the PDP. If the frequency of the sustain signal applied to the sustain electrode pairs is equal to 200 kHz, then P = T1 +T2+T3+T4+T5 = 2.5 $\mu$s.

Thus, taking A = 100 V, T = T1+T2+T3 (pulse duration) = 100 ns and C = 6 nF (capacitance of the columns controlled by the driver circuit D corresponding, for example, to 1/27 of the columns of the PDP), then: L = 170 nH, V1 = 4 V and V2 = 96 V.

This first embodiment uses only a single switching element S to implement the method.

Figures 7, 8 and 9A to 9F illustrate a second embodiment of the device of the invention implementing a method comprising 6 phases of operation. This embodiment is represented in a schematic form in Figure 7. The device (reference 11) differs from that of Figure 4 in that it comprises an additional switching element S' and an additional diode D3. The switching element S' is, for example, an MOS transistor and the diode D3 is the intrinsic diode of this transistor.

The switching element S' is introduced between the end B2 of the solenoid L and a point B3 corresponding to the positive terminal of the voltage source G1 and to the negative terminal of the voltage source G2. The diode D3 is mounted in parallel with the switching element S', with the cathode at the B3 end. With this device, the generation of the pulse signal comprises an additional phase, namely an idle phase at the end of the cycle, as illustrated in Figure 8. In order to integrate this new phase into the signal generation cycle, the duration T5 of the last phase of the signal is shortened and the sixth phase, of duration T6, corresponds to the remaining time of the period P of the signal.

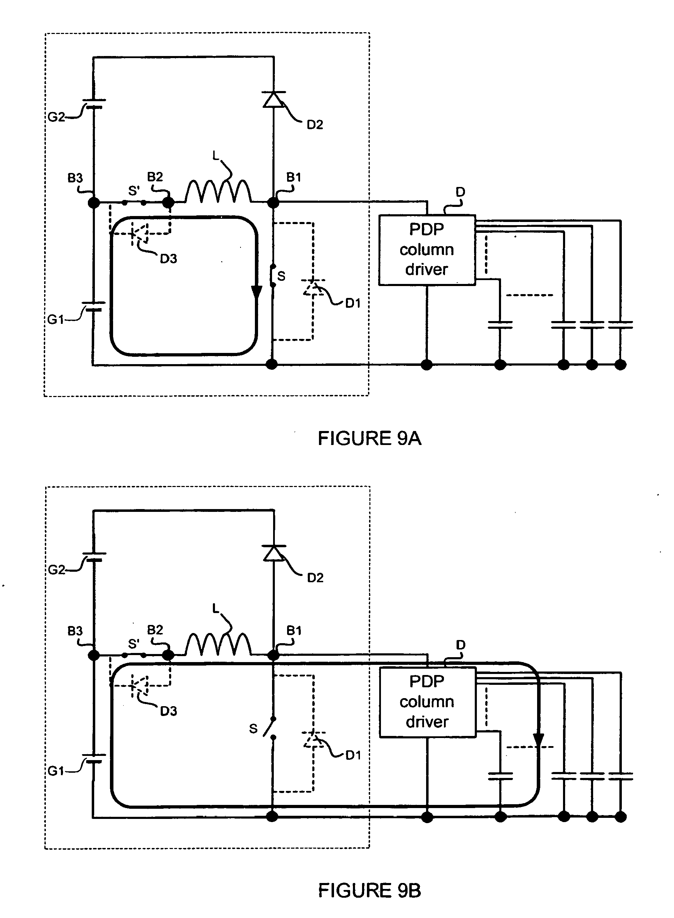

The six phases of the signal generation are individually illustrated by Figures 9A to 9F. The first 5 phases, respectively illustrated by Figures 9A to 9E, are identical to those in Figures 6A to 6E.

During the phase of duration T1 (Figure 9A), the switching elements S and S' are in the closed state. A current $I_L$ flows through the circuit formed by the voltage source G1, the solenoid L and the two switching elements S and S'. The current $I_L$ is negative during this period. Since the input of the driver circuit D is short-circuited to earth by the switching element S, the voltage across the terminals of the PDP columns is zero.

During the phase of duration T2 (Figure 9B), the switching element S is open and the switching element S' is held in the closed state. A part of the energy stored in the solenoid L is discharged into the PDP columns up to the point where the voltage across the column terminals reaches the desired value A.

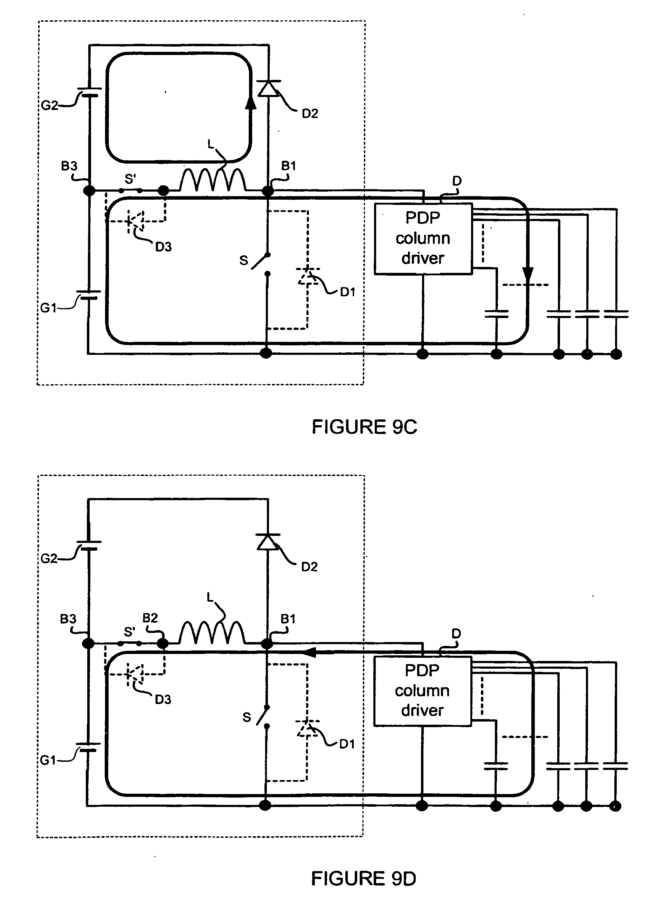

With reference to Figure 9C, this voltage across the terminals of the PDP columns is maintained during the next phase of duration T3 until the point when the current $I_L$ flowing through the solenoid has fallen to zero. During this phase, the state of the switching elements S and S' is unchanged. The current remaining in the solenoid L is, for the one part, transferred into the columns comprising cells in the written state and, for the other, absorbed by the voltage source G2 via the diode D2.

When the solenoid has completely discharged itself, the capacitive energy stored in the capacitors of the PDP columns is restored to the solenoid L, as shown in Figure 9D. The current $I_L$ now changes direction. The voltage across the terminals of the PDP columns falls to zero. During this phase, the state of the switching elements S and S' remains unchanged with respect to the previous phase.

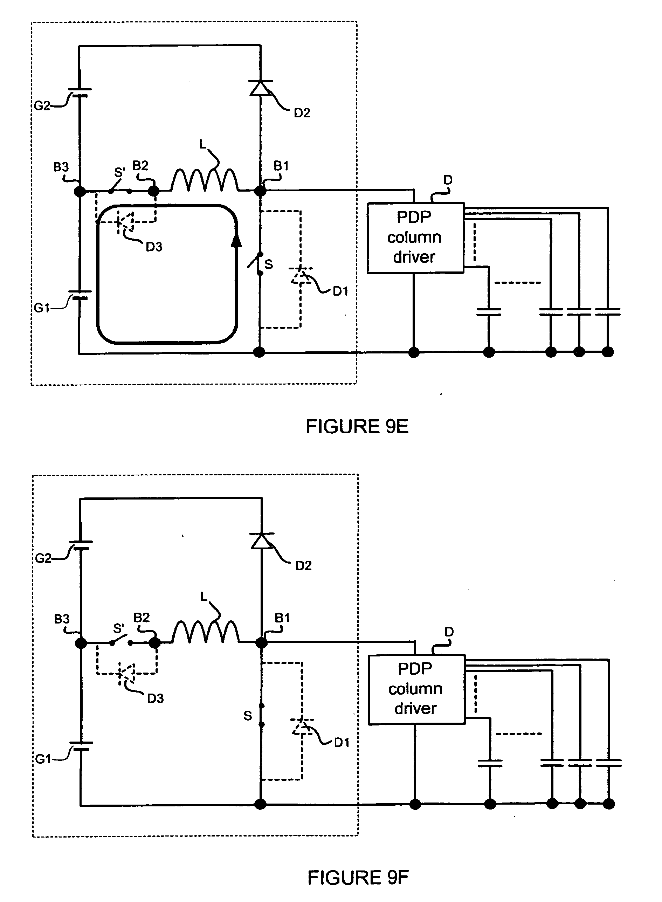

The energy stored in the solenoid L is discharged into the voltage source G1 until the current $I_L$ has become zero. During this period of duration T5, illustrated by Figure 9E, the state of the switching elements, open or closed, is irrelevant since, if they were in the open state, the current $I_L$ would flow through the diodes D1 and D3.

When the current $I_L$ is zero, the switching elements S and S' are set in the closed and open state, respectively. An idle phase (Figure 9F) then begins during which the voltage across the terminals of the PDP columns remains at zero. This additional phase of duration T6 allows the efficiency of the device to be improved, as is explained below.

For this device, the voltage values V1 and V2 are determined as for the first device, namely:

$$- \frac{V1}{V2} \approx \frac{T2 + T3 + T4}{T1 + T5}$$

$$- V1 + V2 = A$$

- T2 + T3 + T4 = $\pi\sqrt{LC}$ where C is the capacitive load of the group of columns controlled by the driver circuit D.

Furthermore, for these two embodiments (Figure 4 and Figure 7), the ratio $\frac{V1}{V2}$ is determined so as to minimize the energy losses within the circuit which are of two types: conduction losses (by ohmic heating in the device and the columns of the circuit) and switching losses.

The conduction losses mainly occur during the phases T1 and T5. They are therefore proportional to the duration T1+T5.

The switching losses are generated by the switching element S and the switches in the column driver circuit. They are negligible if the switching time of the switches is small relative to the durations T1 and T5.

These losses also depend on the component technology employed in the circuit.

In practice, the best efficiencies are obtained for (T1+T5)≈(T2+T3+T4), which is not possible in the first embodiment since a pulse length of 100 ns (= T2+T3+T4) for a period P of around 2.5 $\mu$s (=T1+T2+T3+T4+T5) is desired.

The addition of the idle phase of duration T6 in the second embodiment allows the device efficiency to be increased from a value of less than 50% to over 80%, since this idle phase allows the duration T1 +T5 to be adjusted so that it approaches that of T2+T3+T4.

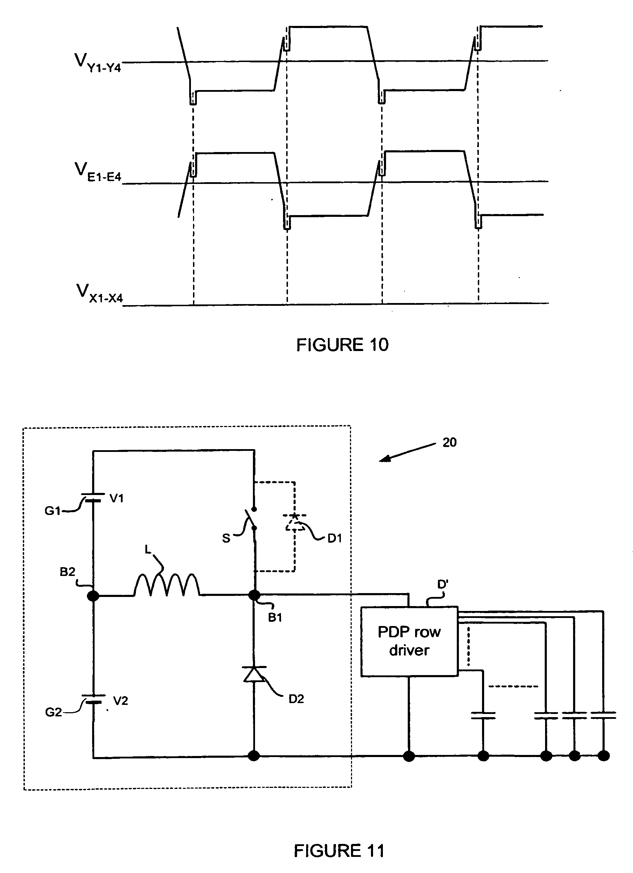

As was indicated at the beginning of the present description of the invention, instead of applying pulses of positive amplitude to the PDP columns during the cell sustain phase, negative pulses can be applied to the rows of the PDP, as illustrated in Figure 10. These pulses are added to the sustain pulses already applied to the rows. In this case, the voltage on the column electrodes of the PDP is kept at zero during the cell sustain phase of the display.

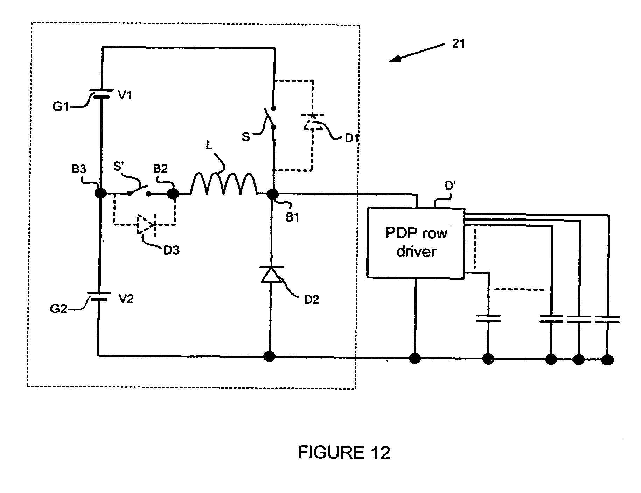

Devices, with references 20 and 21, implementing this method are proposed in Figures 11 and 12, respectively.

The circuit diagram of the device presented in Figure 11 is to be compared with that in Figure 4. The elements of the device of Figure 4 are configured differently in Figure 11. The pulse signal generated is supplied to the rows of the PDP via a row driver D'.

The solenoid L of the device 20 is connected by its end B1 to a group of row electrodes of the PDP via the driver circuit D'. The end B2 of the solenoid is connected to the positive terminal of the voltage source G2. The negative terminal of the source G2 is connected to earth. The diode D2 is connected between the end B1 and earth with its cathode at the B1 end.

The negative terminal of the voltage source G1 is connected to the end B2 and its positive terminal is connected, via the switching element S, to the end B1. The diode D1, mounted in parallel with the switch S, has its cathode connected to the positive terminal of the source G1 and its anode connected to the end B1.

Another device circuit diagram is presented in Figure 12. It is to be compared with that in Figure 7. In this figure, the switching element S' is located between the end B2 of the solenoid L and the point B3 corresponding to the positive terminal of the voltage source G2. The diode D3 is mounted in parallel with the switching element S' with its cathode at the B2 end.

The operation of these two devices can readily be deduced from those of Figures 4 and 7.

The application of these pulses to the rows or columns of the PDP during the sustain phase allows the luminous efficiency of the discharges within the PDP cells to be significantly improved, and allows the discharges to be phase-shifted from one group of rows to the other, or from one group of columns to the other, by employing several pulse generators that are phase-shifted with respect to one another.

**Claims**

1. Method for generating a periodic voltage signal, of period P, comprising pulses of short duration T and of high amplitude A to be applied to a plurality of columns or rows of a plasma display panel comprising a plurality of cells located at the intersections of said rows and columns, where the cells can be in a written state or an erased state, **characterized in that** it comprises the following steps:

   - during a first phase of duration T1, applying a first DC voltage across the terminals of a solenoid so that the latter stores current in the form of magnetic energy;
   - during a second phase of duration T2, applying a voltage of amplitude A across the terminals of the capacitors of said plurality of columns or rows of the plasma display and discharging into the latter a part of the current stored in the solenoid up to the point where the voltage across the terminals of the capacitors of said plurality of columns or rows of the plasma display reaches the amplitude A;
   - during a third phase of duration T3, maintaining said voltage of amplitude A across the terminals of said plurality of plasma display columns or rows so as to create a matrix discharge current between the columns and rows of the plasma display cells in the written state and bring the current stored in said solenoid to zero;
   - during a fourth phase of duration T4, charging the solenoid with the current stored in the form of capacitive energy in the capacitors of said plurality of columns or rows of the plasma display until the point when the voltage across the terminals of the capacitors has fallen to zero;
   - during a fifth phase of duration T5, bringing the current stored in the solenoid to zero.

2. Method according to Claim 1, **characterized in that**, during said second and third phases, the voltage of amplitude A applied across the terminals of the capacitors of said plurality of columns or rows of the plasma display is generated by summation of the first DC voltage with a second DC voltage, the ratio of said first DC voltage to said second DC voltage being equal to, or very close to, the ratio of the sum T2+T3+T4 to the sum T1+T5, and **in that**, for a solenoid of inductance L and a plurality of columns or rows of total capacitance equal to C, the duration T of the pulse equal to T2+T3+T4 is defined such that

$$T2+T3+T4 \approx \pi\sqrt{LC}.$$

3. Method according to Claim 2, **characterized in that** it comprises an additional phase, consecutive to the fifth phase, of duration T6 corresponding to an idle phase, during which no current is supplied to said plurality of columns or rows of the plasma display and the voltage across the terminals of the latter is maintained at zero.

4. Method according to either of Claims 2 and 3, **characterized in that** the first and second DC voltages are generated by first and second DC voltage generators, respectively.

5. Method according to Claim 4, **characterized in that**, during the third phase, the matrix discharge current is supplied by said solenoid and **in that** the current remaining in the solenoid is absorbed by the second DC voltage generator so as to bring the current stored in said solenoid to zero.

6. Method according to either of Claims 4 and 5, **characterized in that**, during the fifth phase, the current remaining in the solenoid is absorbed by the first DC voltage generator so as to bring the current stored in said solenoid to zero.

7. Device for implementing the method according to Claim 2, where the generated voltage is applied to a plurality of columns of the plasma display panel, **characterized in that** the device comprises:

  - a solenoid (L) of which a first end (B1) is connected to said plurality of columns;
  - a first DC voltage generator (G1) whose positive terminal is connected to a second end (B2) of said solenoid (L) and whose negative terminal is connected to earth, which first generator is designed to generate said first DC voltage V1;
  - a first switching element (S) connected between the first end (B1) of the solenoid and earth, which first switching element is in the closed position during said first and fifth phases and in the open position during said second, third and fourth phases;
  - a second DC voltage generator (G2) whose negative terminal is connected to the positive terminal of the first voltage generator (G1) and whose positive terminal is connected, via a first diode (D2), to the first end (B1) of the solenoid, the cathode and the anode of said first diode being respectively connected to the positive terminal of said second DC voltage generator (G2) and to the first end (B1) of said solenoid, which second DC voltage generator is designed to generate, in cooperation with the first DC voltage generator (G1), the voltage of amplitude A.

8. Device for implementing the method according to Claim 4, itself depending on claim 3, where the generated voltage is applied to a plurality of columns of the plasma display panel, **characterized in that** it comprises:

  - a solenoid (L) of which a first end (B1) is connected to said plurality of columns;
  - a first switching element (S) connected between the first end (B1) of the solenoid and earth, which first switching element is in the closed position during the first, fifth and sixth phases and in the open position during the second, third and fourth phases;
  - a first DC voltage generator (G1) whose positive terminal is connected, via a second switching element (S'), to a second end (B2) of said solenoid (L) and whose negative terminal is connected to earth, which first generator designed to generate said first DC voltage V1, said second switching element (S') being in the closed position during the first five phases and in the open position during the sixth phase;
  - a second DC voltage generator (G2) whose negative terminal is connected to the positive terminal of the first voltage generator (G1) and whose positive terminal is connected, via a first diode (D2), to the first end (B1) of the solenoid, the cathode and the anode of said first diode being respectively connected to the positive terminal of said second DC voltage generator (G2) and to the first end (B1) of said solenoid, which second DC voltage generator is designed to generate, in cooperation with the first DC voltage generator (G1), the voltage of amplitude A.

9. Device for implementing the method according to Claim 2, where the generated voltage is applied to a plurality of rows of the plasma display panel, **characterized in that** it comprises:

  - a solenoid (L) of which a first end (B1) is connected to said plurality of rows;
  - a first DC voltage generator (G1) whose negative terminal is connected to a second end (B2) of said solenoid (L) and whose positive terminal is connected, via a switching element (S), to said first end (B1), said first generator being designed to generate said first DC voltage V1, said switching element being in the closed position during said first and fifth phases and in the open position during said second, third and fourth phases;
  - a second DC voltage generator (G2) whose positive terminal is connected to the negative terminal of the first voltage generator (G1) and whose negative terminal is connected to earth, which second DC voltage generator is designed to generate, in cooperation with the first DC voltage generator (G1), the voltage of amplitude A,
  - a diode (D2) whose cathode and anode are connected to said first end (B1) of said solenoid and to earth, respectively.

10. Device for implementing the method according to Claim 4, itself depending on claim 3, where the generated voltage is applied to a plurality of rows of the plasma display panel, **characterized in that** the device comprises:

- a solenoid (L) of which a first end (B1) is connected to said plurality of rows;
- a first DC voltage generator (G1) whose positive terminal is connected, via a first switching element (S), to the first end (B1) of the solenoid (L) and the negative terminal is connected, via a second switching element (S'), to a second end (B2) of said solenoid (L), said first generator being designed to generate said first DC voltage V1, said first switching element (S) being in the closed position during the first, fifth and sixth phases and in the open position during the second, third and fourth phases, and said second switching element (S') being in the closed position during the first five phases and in the open position during the sixth phase;
- a second DC voltage generator (G2) whose positive terminal is connected to the negative terminal of the first voltage generator (G1) and whose positive terminal is connected to earth, which second DC voltage generator is designed to generate, in cooperation with the first DC voltage generator (G1), the voltage of amplitude A;
- a diode (D2) whose cathode and anode are connected to the first end (B1) of the solenoid and to earth, respectively.

11. Device according to one of Claims 7 to 10, **characterized in that** said first and second switching elements (S, S') are MOS transistors.

12. Plasma display panel comprising a plurality of cells located at the intersections of rows and columns, a row driver circuit and a column driver circuit, **characterized in that** it also comprises a device according to one of Claims 7 to 11.

**Patentansprüche**

1. Verfahren zum Erzeugen eines periodischen Spannungssignals mit einer Periode P, das Impulse von kurzer Dauer T und mit hoher Amplitude A umfasst, die an eine Mehrzahl von Spalten oder Zeilen eines Plasmaanzeigebildschirms angelegt werden sollen, der eine Mehrzahl von Zellen umfasst, die sich an den Schnittpunkten der Zeilen und Spalten befinden, wobei die Zellen in einem beschriebenen Zustand oder in einem gelöschten Zustand sein können, **dadurch gekennzeichnet, dass** das Verfahren die folgenden Schritte umfasst:

- während einer ersten Phase mit der Dauer T1, Anlegen einer ersten Gleichspannung über die Anschlüsse eines Solenoids, so dass das Letztere Strom in Form magnetischer Energie speichert;
- während einer zweiten Phase mit der Dauer T2, Anlegen einer Spannung mit der Amplitude A über die Anschlüsse der Kondensatoren der Mehrzahl von Spalten oder Zeilen der Plasmaanzeige und Entladen eines Teils des in dem Solenoid gespeicherten Stroms in die Letzteren bis zu dem Punkt, an dem die Spannung über die Anschlüsse der Kondensatoren der Mehrzahl von Spalten oder Zeilen der Plasmaanzeige die Amplitude A erreicht;
- während einer dritten Phase mit der Dauer T3, Aufrechterhalten der Spannung mit der Amplitude A über die Anschlüsse der Mehrzahl von Plasmaanzeigespalten oder
- zeilen, um in dem beschriebenen Zustand zwischen den Spalten und Zeilen der Plasmaanzeigezellen einen Matrixentladestrom zu erzeugen und den in dem Solenoid gespeicherten Strom auf null zu bringen,
- während einer vierten Phase mit der Dauer T4, Laden des Solenoids mit dem in Form von kapazitiver Energie in den Kondensatoren der Mehrzahl von Spalten oder Zeilen der Plasmaanzeige gespeicherten Strom bis zu dem Punkt, an dem die Spannung über die Anschlüsse der Kondensatoren auf null gefallen ist,
- während einer fünften Phase mit der Dauer T5, Bringen des in dem Solenoid gespeicherten Stroms auf null.

2. Verfahren nach Anspruch 1, **dadurch gekennzeichnet, dass** während der zweiten und dritten Phase die Spannung mit der Amplitude A, die über die Anschlüsse der Kondensatoren der Mehrzahl von Spalten oder Zeilen der Plasmaanzeige angelegt wird, durch Summation der ersten Gleichspannung mit einer zweiten Gleichspannung erzeugt wird, wobei das Verhältnis der ersten Gleichspannung zu der zweiten Gleichspannung gleich oder sehr nahe dem Verhältnis der Summe T2 + T3 + T4 zu der Summe T1 + T5 ist, und **dadurch**, dass für ein Solenoid mit der Induktivität L und mit einer Mehrzahl von Spalten oder Zeilen mit einer Gesamtkapazität gleich C die Dauer T des Impulses gleich T2 + T3 + T4 so definiert ist, dass

$$T2 + T3 + T4 \approx \pi\sqrt{LC}$$

ist.

3. Verfahren nach Anspruch 2, **dadurch gekennzeichnet, dass** es eine zusätzliche Phase, die auf die fünfte Phase folgt, mit der Dauer T6 umfasst, die einer Leerlaufphase entspricht, während der der Mehrzahl von Spalten oder Zeilen der Plasmaanzeige kein Strom zugeführt wird und die Spannung über die Anschlüsse der Letzteren auf null gehalten wird.

4. Verfahren nach einem der Ansprüche 2 und 3, **dadurch gekennzeichnet, dass** die erste und die zweite Gleichspannung durch einen ersten bzw. einen zweiten Gleichspannungsgenerator erzeugt werden.

5. Verfahren nach Anspruch 4, **dadurch gekennzeichnet, dass** während der dritten Phase der Matrixentladestrom durch das Solenoid zugeführt wird und dass der in dem Solenoid bleibende Strom durch den zweiten Gleichspannungsgenerator absorbiert wird, um den in dem Solenoid gespeicherten Strom auf null zu bringen.

6. Verfahren nach einem der Ansprüche 4 oder 5, **dadurch gekennzeichnet, dass** während der fünften Phase der in dem Solenoid verbleibende Strom durch den ersten Gleichspannungsgenerator aufgenommen wird, um den in dem Solenoid gespeicherten Strom auf null zu bringen.

7. Vorrichtung zum Implementieren des Verfahrens nach Anspruch 2, bei der die erzeugte Spannung an eine Mehrzahl von Spalten des Plasmaanzeigebildschirms angelegt wird, **dadurch gekennzeichnet, dass** die Vorrichtung umfasst:

- ein Solenoid (L), von dem ein erstes Ende (B1) mit der Mehrzahl von Spalten verbunden ist;
- einen ersten Gleichspannungsgenerator (G1), dessen positiver Anschluss mit einem zweiten Ende (B2) des Solenoids (L) verbunden ist und dessen negativer Anschluss mit Masse verbunden ist, wobei der erste Generator zum Erzeugen der ersten Gleichspannung V1 ausgelegt ist,
- ein erstes Schaltelement (S), das zwischen das erste Ende (B1) des Solenoids und Masse geschaltet ist, wobei das erste Schaltelement während der ersten und fünften Phase in der geschlossenen Stellung ist und während der zweiten, dritten und vierten Phase in der offenen Stellung ist;
- einen zweiten Gleichspannungsgenerator (G2), dessen negativer Anschluss mit dem positiven Anschluss des ersten Spannungsgenerators (G1) verbunden ist und dessen positiver Anschluss über eine erste Diode (D2) mit dem ersten Ende (B1) des Solenoids verbunden ist, wobei die Katode und die Anode der ersten Diode mit dem positiven Anschluss des zweiten Gleichspannungsgenerators (G2) bzw. mit dem ersten Ende (B1) des Solenoids verbunden sind, wobei der zweite Gleichspannungsgenerator zum Erzeugen der Spannung mit der Amplitude A im Zusammenwirken mit dem ersten Gleichspannungsgenerator (G1) ausgelegt ist.

8. Vorrichtung zum Implementieren des Verfahrens nach Anspruch 4, selbst abhängig von Anspruch 3, wobei die erzeugte Spannung an eine Mehrzahl von Spalten des Plasmaanzeigebildschirms angelegt wird, **dadurch gekennzeichnet, dass** die Vorrichtung umfasst:

- ein Solenoid (L), von dem ein erstes Ende (B1) mit der Mehrzahl von Spalten verbunden ist;
- ein erstes Schaltelement (S), das zwischen das erste Ende (B1) des Solenoids und Masse geschaltet ist, wobei das erste Schaltelement während der ersten, fünften und sechsten Phase in der geschlossenen Stellung ist und während der zweiten, dritten und vierten Phase in der offenen Stellung ist;
- einen ersten Gleichspannungsgenerator (G1), dessen positiver Anschluss über ein zweites Schaltelement (S') mit einem zweiten Ende (B2) des Solenoids (L) verbunden ist und dessen negativer Anschluss mit Masse verbunden ist, wobei der erste Generator zum Erzeugen der ersten Gleichspannung V1 ausgelegt ist und wobei das zweite Schaltelement (S') während der ersten fünf Phasen in der geschlossenen Stellung ist und während der sechsten Phase in der offenen Stellung ist;
- einen zweiten Gleichspannungsgenerator (G2), dessen negativer Anschluss mit dem positiven Anschluss des ersten Spannungsgenerators (G1) verbunden ist und dessen positiver Anschluss über eine erste Diode (D2) mit dem ersten Ende (B1) des Solenoids verbunden ist, wobei die Katode und die Anode der ersten Diode mit dem positiven Anschluss des zweiten Gleichspannungsgenerators (G2) bzw. mit dem ersten Ende (B1) des Solenoids verbunden sind, wobei der zweite Gleichspannungsgenerator zum Erzeugen der Spannung mit der Amplitude A im Zusammenwirken mit dem ersten Gleichspannungsgenerator (G1) ausgelegt ist.

9. Vorrichtung zum Implementieren des Verfahrens nach Anspruch 2, bei der die erzeugte Spannung an eine Mehrzahl von Zeilen des Plasmaanzeigebildschirms angelegt wird, **dadurch gekennzeichnet, dass** die Vorrichtung umfasst:

- ein Solenoid (L), von dem ein erstes Ende (B1) mit der Mehrzahl von Zeilen verbunden ist;
- einen ersten Gleichspannungsgenerator (G1), dessen negativer Anschluss mit einem zweiten Ende (B2) des Solenoids (L) verbunden ist und dessen positiver Anschluss über ein Schaltelement (S) mit dem ersten Ende (B1) verbunden ist, wobei der erste Generator zum Erzeugen der ersten Gleichspannung V1 ausgelegt ist, wobei das Schaltelement während der ersten und der fünften Phase in der geschlossenen Stellung ist und während der zweiten, dritten und vierten Phase in der offenen Stellung ist;
- einen zweiten Gleichspannungsgenerator (G2), dessen positiver Anschluss mit dem negativen Anschluss des ersten Spannungsgenerators (G1) verbunden ist und dessen negativer Anschluss mit Masse verbunden ist, wobei der zweite Gleichspannungsgenerator zum Erzeugen der Spannung mit der Amplitude A im Zusammenwirken mit dem ersten Gleichspannungsgenerator (G1) ausgelegt ist,
- eine Diode (D2), deren Katode und Anode mit dem ersten Ende (B1) des Solenoids bzw. mit Masse verbunden sind.

10. Vorrichtung zum Implementieren des Verfahrens nach Anspruch 4, selbst abhängig von Anspruch 3, bei der die erzeugte Spannung an eine Mehrzahl von Zeilen des Plasmaanzeigebildschirms angelegt wird, **dadurch gekennzeichnet, dass** die Vorrichtung umfasst:

- ein Solenoid (L), von dem ein erstes Ende (B1) mit der Mehrzahl von Zeilen verbunden ist;
- einen ersten Gleichspannungsgenerator (G1), dessen positiver Anschluss über ein erstes Schaltelement (S) mit dem ersten Ende (B1) des Solenoids (L) verbunden ist und dessen negativer Anschluss über ein zweites Schaltelement (S') mit einem zweiten Ende (B2) des Solenoids (L) verbunden ist, wobei der erste Generator zum Erzeugen der ersten Gleichspannung V1 ausgelegt ist, wobei das erste Schaltelement (S) während der ersten, fünften und sechsten Phase in der geschlossenen Stellung ist und während der zweiten, dritten und vierten Phase in der offenen Stellung ist, und wobei das zweite Schaltelement (S') während der ersten fünf Phasen in der geschlossenen Stellung ist und während der sechsten Phase in der offenen Stellung ist;
- einen zweiten Gleichspannungsgenerator (G2), dessen positiver Anschluss mit dem negativen Anschluss des ersten Spannungsgenerators (G1) verbunden ist und dessen positiver Anschluss mit Masse verbunden ist, wobei der zweite Gleichspannungsgenerator zum Erzeugen der Spannung mit der Amplitude A im Zusammenwirken mit dem ersten Gleichspannungsgenerator (G1) ausgelegt ist;
- eine Diode (D2), deren Katode und Anode mit dem ersten Ende (B1) des Solenoids bzw. mit Masse verbunden sind.

11. Vorrichtung nach einem der Ansprüche 7 bis 10, **dadurch gekennzeichnet, dass** das erste und das zweite Schaltelement (S, S') MOS-Transistoren sind.

12. Plasmaanzeigebildschirm, der eine Mehrzahl von Zellen, die sich an den Schnittpunkten der Zeilen und Spalten befinden, eine Zeilentreiberschaltung und eine Spaltentreiberschaltung umfasst, **dadurch gekennzeichnet, dass** er außerdem eine Vorrichtung nach einem der Ansprüche 7 bis 11 umfasst.

## Revendications

1. Méthode pour la génération d'un signal de tension périodique, de période P, comprenant des impulsions de courte durée T et d'amplitude élevée A à appliquer à une pluralité de colonnes ou de rangées d'un afficheur plasma comprenant une pluralité de cellules situées au niveau des intersections desdites rangées et colonnes, où les cellules peuvent être dans un état d'écriture ou un état d'effacement, **caractérisé en ce qu'**elle comprend les étapes suivantes :

- lors d'une première phase de durée T1, application d'une première tension CC traversant les bornes d'un solénoïde, de sorte que ce dernier stocke le courant sous la forme d'une énergie magnétique ;
- lors d'une deuxième phase de durée T2, application d'une tension d'amplitude A traversant les bornes des condensateurs de ladite pluralité de colonnes ou de rangées de l'afficheur plasma et déchargement dans ce dernier d'une partie du courant stocké dans le solénoïde jusqu'au point où la tension traversant les bornes des condensateurs de ladite pluralité de colonnes ou de rangées de l'écran plasma atteint l'amplitude A ;
- lors d'une troisième phase de durée T3, maintien de ladite tension d'amplitude A traversant les bornes de ladite pluralité de colonnes ou de rangées de l'afficheur plasma de sorte à créer un courant de décharge de matrice entre les colonnes et les rangées des cellules de l'afficheur plasma dans l'état d'écriture et amener le courant stocké dans ledit solénoïde à zéro ;
- lors d'une quatrième phase de durée T4, chargement du solénoïde avec le courant stocké sous la forme d'une énergie capacitive dans les condensateurs de ladite pluralité de colonnes ou de rangées de l'afficheur plasma jusqu'au point auquel la tension traversant les bornes des condensateurs a atteint zéro ;

- lors d'une cinquième phase de durée T5, amener le courant stocké dans le solénoïde à zéro.

2. Méthode selon la revendication 1, **caractérisée en ce que**, lors desdites deuxième et troisième phases, la tension d'amplitude A appliquée sur les bornes des condensateurs de ladite pluralité de colonnes ou de rangées de l'afficheur plasma est générée par une sommation de la première tension CC avec une deuxième tension CC, le ratio de ladite première tension CC par rapport à ladite deuxième tension CC étant égal à ou très proche du ratio de la somme T2+T3+T4 par rapport à la somme T1+T5, et **en ce que**, pour un solénoïde d'inductance L et une pluralité de colonnes ou de rangées d'une capacité totale égale à C, la durée T de l'impulsion égale à T2+T3+T4 est définie de sorte que $T2+T3+T4 \approx \pi \sqrt{LC}$.

3. Méthode selon la revendication 2, **caractérisée en ce qu'**elle comprend une phase supplémentaire, consécutive à la cinquième phase, de durée T6 correspondant à une phase inactive, lors de laquelle aucun courant n'est fourni à ladite pluralité de colonnes ou de rangées de l'afficheur plasma et la tension traversant les bornes de ce dernier est maintenue à zéro.

4. Méthode selon une quelconque des revendications 2 et 3, **caractérisée en ce que** les première et deuxième tensions CC sont générées par des premier et deuxième générateurs de tension CC, respectivement.

5. Méthode selon la revendication 4, **caractérisée en ce que**, lors de la troisième phase, le courant de décharge de matrice est fourni par ledit solénoïde et **en ce que** le courant restant dans le solénoïde est absorbé par le deuxième générateur de tension CC de sorte à amener le courant stocké dans ledit solénoïde à zéro.

6. Méthode selon une quelconque des revendications 4 et 5, **caractérisée en ce que**, lors de la cinquième phase, le courant restant dans le solénoïde est absorbé par le premier générateur de tension CC de sorte à amener le courant stocké dans ledit solénoïde à zéro.

7. Dispositif pour la mise en oeuvre de la méthode selon la revendication 2, où la tension générée est appliquée à une pluralité de colonnes de l'afficheur plasma, **caractérisée en ce que** le dispositif comprend :

    - un solénoïde (L) dont une première extrémité (B1) est connectée à ladite pluralité de colonnes ;
    - un premier générateur de tension CC (G1) dont la borne positive est connectée à une deuxième extrémité (B2) dudit solénoïde (L) et dont la borne négative est mise à la terre, lequel premier générateur est conçu pour générer ladite première tension CC V1 ;
    - un premier élément de commutation (S) connecté entre la première extrémité (B1) du solénoïde et la terre, lequel premier élément de commutation se trouve en position fermée lors desdites première et cinquième phases et en position ouverte lors desdites deuxième, troisième et quatrième phases ;
    - un deuxième générateur de tension CC (G2) dont la borne négative est connectée à la borne positive du premier générateur de tension (G1) et dont la borne positive est connectée, via une première diode (D2), à la première extrémité (B1) du solénoïde, la cathode et l'anode de ladite première diode étant respectivement connectées à la borne positive dudit deuxième générateur de tension CC (G2) et à la première extrémité (B1) dudit solénoïde, lequel deuxième générateur de tension CC est conçu pour générer, conjointement avec le premier générateur de tension CC (G1), la tension d'amplitude A.

8. Dispositif pour la mise en oeuvre de la méthode selon la revendication 4, dépendant elle-même de la revendication 3, où la tension générée est appliquée à une pluralité de colonnes de l'afficheur plasma, **caractérisé en ce qu'**il comprend :

    - un solénoïde (L) dont une première extrémité (B1) est connectée à ladite pluralité de colonnes ;
    - un premier élément de commutation (S) connecté entre la première extrémité (B1) du solénoïde et la terre, lequel premier élément de commutation se trouve en position fermée lors des première, cinquième et sixième phases et en position ouverte lors des deuxième, troisième et quatrième phases ;
    - un premier générateur de tension CC (G1) dont la borne positive est connectée, via un deuxième élément de commutation (S'), à une deuxième extrémité (B2) dudit solénoïde (L) et dont la borne négative est mise à la terre, lequel premier générateur est conçu pour générer ladite première tension CC V1, ledit deuxième élément de commutation (S') se trouvant en position fermée lors des cinq premières phases et en position ouverte lors de la sixième phase ;
    - un deuxième générateur de tension CC (G2) dont la borne négative est connectée à la borne positive du premier générateur de tension (G1) et dont la borne positive est connectée, via une première diode (D2), à la première extrémité (B1) du solénoïde, la cathode et l'anode de ladite première diode étant respectivement connectées à la borne positive dudit deuxième générateur de tension CC (G2) et à la première extrémité (B1) dudit solénoïde, lequel deuxième générateur de tension CC est conçu pour générer, conjointement avec le premier générateur de tension CC (G1), la tension d'amplitude A.

9. Dispositif pour la mise en oeuvre de la méthode selon la revendication 2, où la tension générée est appliquée à une pluralité de rangées de l'afficheur plasma, **caractérisé en ce qu'**il comprend :

    - un solénoïde (L) dont une première extrémité (B1) est connectée à ladite pluralité de rangées ;
    - un premier générateur de tension CC (G1) dont la borne négative est connectée à une deuxième extrémité (B2) dudit solénoïde (L) et dont la borne positive est connectée, via un élément de commutation (S), à ladite première extrémité (B1), ledit premier générateur étant conçu pour générer ladite première tension CC V1, ledit élément de commutation se trouvant en position fermée lors desdites première et cinquième phases et en position ouverte lors desdites deuxième, troisième et quatrième phases ;
    - un deuxième générateur de tension CC (G2) dont la borne positive est connectée à la borne négative du premier générateur de tension (G1) et dont la borne négative est mise à la terre, lequel deuxième générateur de tension CC est conçu pour générer, conjointement avec le premier générateur de tension CC (G1), la tension d'amplitude A,
    - une diode (D2) dont la cathode et l'anode sont connectées à ladite première extrémité (B1) dudit solénoïde et à la terre, respectivement.

10. Dispositif pour la mise en oeuvre de la méthode selon la revendication 4, dépendant elle-même de la revendication 3, où la tension générée est appliquée à une pluralité de rangées de l'afficheur plasma, **caractérisé en ce que** le dispositif comprend :

    - un solénoïde (L) dont une première extrémité (B1) est connectée à ladite pluralité de rangées ;
    - un premier générateur de tension CC (G1) dont la borne positive est connectée, via un premier élément de commutation (S), à la première extrémité (B1) du solénoïde (L) et dont la borne négative est connectée, via un deuxième élément de commutation (S'), à une deuxième extrémité (B2) dudit solénoïde (L), ledit premier générateur étant conçu pour générer ladite première tension CC V1, ledit premier élément de commutation (S) se trouvant en position fermée lors des première, cinquième et sixième phases et en position ouverte lors des deuxième, troisième et quatrième phases ; et ledit deuxième élément de commutation (S') se trouvant en position fermée lors des cinq premières phases et en position ouverte lors de la sixième phase ;
    - un deuxième générateur de tension CC (G2) dont la borne positive est connectée à la borne négative du premier générateur de tension (G1) et dont la borne positive est mise à la terre, lequel deuxième générateur de tension CC est conçu pour générer, conjointement avec le premier générateur de tension CC (G1), la tension d'amplitude A ;
    - une diode (D2) dont la cathode et l'anode sont connectées à la première extrémité (B1) du solénoïde et à la terre, respectivement.

11. Dispositif selon une des revendications 7 à 10, **caractérisé en ce que** lesdits premier et deuxième éléments de commutation (S, S') sont des transistors MOS.

12. Afficheur plasma comprenant une pluralité de cellules situées au niveau des intersections des rangées et des colonnes, un circuit d'attaque de rangée et un circuit d'attaque de colonne, **caractérisé en ce qu'**il comprend également un dispositif selon une des revendications 7 à 11.

FIGURE 1

FIGURE 2

$V_{Y1-Y4}$

$V_{E1-E4}$

$V_{X1-X4}$

FIGURE 3

G2 —⊣⊦ V2

D2

L

B2

B1

S

D1

G1 —⊣⊦ V1

10

PDP
column
driver

D

FIGURE 4

15

$A = V1 + V2$

FIGURE 5

column
driver

FIGURE 6A

FIGURE 6B

FIGURE 6C

**FIGURE 6D**

**FIGURE 6E**

FIGURE 7

FIGURE 8

FIGURE 9A

FIGURE 9B

**FIGURE 9C**

**FIGURE 9D**

FIGURE 9E

FIGURE 9F

FIGURE 10

FIGURE 11

FIGURE 12

**REFERENCES CITED IN THE DESCRIPTION**

**Patent documents cited in the description**

- FR 2417848
- EP 0135382 A

- WO 02099779 A